# EUROPÄISCHE PATENTSCHRIFT

(11) **EP 3 169 467 B1**
(45) Veröffentlichungstag und Bekanntmachung des Hinweises auf die Patenterteilung: **17.10.2018**
(21) Anmeldenummer: 15747104.6
(22) Anmeldetag: 15.07.2015
(51) Int. Cl.: B23K 1/00, B23K 3/06, H05K 3/34, B23K 101/42

(54) **LOTKUGELZUFÜHREINRICHTUNG MIT EINER ULTRASCHALLEINRICHTUNG UND EINEM DRUCKANSCHLUSS**
SOLDER SPHERE FEEDING DEVICE WITH AN ULTRASONIC SYSTEM AND A PRESSURE LINE
DISPOSITIF D'ALIMENTATION EN BILLES DE BRASURE AVEC UN DISPOSITIF ULTRASONS ET UNE CONNECTION POUR MISE EN PRESSION

(30) Priorität: 15.07.2014 DE 102014109890
(43) Veröffentlichungstag der Anmeldung: 24.05.2017
(73) Patentinhaber: Pac Tech - Packaging Technologies GmbH, 14641 Nauen (DE)
(72) Erfinder: AZDASHT, Ghassem, 13591 Berlin (DE)
(74) Vertreter: advotec.
(86) Internationale Anmeldenummer: PCT/EP2015/066194
(87) Internationale Veröffentlichungsnummer: WO 2016/008939

(56) Entgegenhaltungen:
- US-A1- 2002 053 591
- US-A1- 2010 213 243
- US-B1- 6 253 985

## Beschreibung

Die Erfindung betrifft eine Lotkugelzuführeinrichtung gemäß dem Oberbegriff des Anspruchs 1 (siehe, z.B., US6 253985 B1).

Aus der DE 10 2004 051 983 A1 ist eine Lotkugeltransfervorrichtung bekannt mit einem Transfersubstrat und einer Entnahmeeinrichtung. Bei der bekannten Vorrichtung ist das als Lochschablone ausgebildete Transfersubstrat oberhalb der Entnahmeeinrichtung angeordnet, wobei das Transfersubstrat mit einem Vakuum beaufschlagt wird, um unterhalb des Transfersubstrats in der Entnahmeeinrichtung regellos verteilt angeordnete Lotkugeln anzusaugen und für eine Anordnung der Lotkugeln entsprechend dem Lochmuster der Schablone zu sorgen.

Für die einwandfreie Funktion der bekannten Vorrichtung ist es notwendig, dass die Entnahmeeinrichtung einen ausreichenden Füllstand mit Lotkugeln aufweist, so dass während eines kontinuierlichen Betriebs der Vorrichtung die Entnahmeeinrichtung immer wieder nachgefüllt werden muss. Dabei hat es sich herausgestellt, dass möglichst geringe Füllstandsänderungen, die das Auffüllen der Entnahmeeinrichtung mit möglichst genau definierten Nachfüllmengen erfordern, vorteilhaft sind.

Der vorliegenden Erfindung liegt die Aufgabe zugrunde, eine Vorrichtung der eingangs genannten Art vorzuschlagen, die ein Auffüllen der Entnahmeeinrichtung mit einer möglichst exakten dosierten Lotkugelmenge ermöglicht.

Zur Lösung dieser Aufgabe weist die erfindungsgemäße Vorrichtung die Merkmale des Anspruchs 1 auf.

Die erfindungsgemäße Lotkugelzuführvorrichtung weist ein Lotkugelreservoir zur Aufnahme einer Lotkugelmenge und eine Dosiereinrichtung zur Ausgabe einer dosierten Zuführmenge von Lotkugeln an eine Entnahmeeinrichtung auf. Die Dosiereinrichtung umfasst eine Ultraschalleinrichtung und ein Ausgabemundstück mit einer Ausgabekanüle, wobei die Ultraschalleinrichtung zur Beaufschlagung des Ausgabemundstücks mit Schwingungen dient und das Lotkugelreservoir oder das Ausgabemundstück des Lotkugelreservoirs mit einem Druckanschluss versehen ist, der zur Einleitung eines unter Druck stehenden Gases in die Lotkugelzuführeinrichtung dient.

Die Ultraschalleinrichtung ermöglicht eine Beaufschlagung des Ausgabemundstücks mit Schwingungen, so dass eine "Ventilfunktion" an der Dosiereinrichtung ohne die Verwendung mechanischer, beweglicher Ventilelemente möglich wird. Vielmehr ist die Schließfunktion des "Ventils" dadurch bewirkt, dass sich bei einer nicht erfolgenden Ultraschallbeaufschlagung des Ausgabemundstücks die Lotkugeln in der Ausgabekanüle des Ausgabemundstücks gegeneinander verkeilen, so dass der Durchgang durch die Ausgabekanüle versperrt ist. Eine Beaufschlagung des Ausgabemundstücks mit Ultraschallschwingungen sorgt dafür, dass die in der Ausgabekanüle gegeneinander liegenden Lotkugeln schwingungsinduziert aufeinander gleiten und so die Blockade in der Ausgabekanüle unter Ultraschallbeaufschlagung gelöst wird und ein Nachströmen von oberhalb des Ausgabemundstücks im Lotkugelreservoir angeordneten Lotkugeln unterstützt durch eine Druckbeaufschlagung der Lotkugeln mit einem Gas durch die Ausgabekanüle erfolgen kann.

Die Schwingungsbeaufschlagung des Ausgabemundstücks kann unmittelbar durch direkte Einwirkung der Ultraschalleinrichtung auf das Ausgabemundstück oder mittelbar durch Einwirkung der Ultraschalleinrichtung auf andere Bereiche oder Teile des Lotkugelreservoirs erfolgen.

Die Ultraschalleinrichtung kann unabhängig vom Ausgabemundstück ausgebildet sein, wobei es vorteilhaft ist, wenn die Ultraschalleinrichtung an einem Behälterkörper des Lotkugelreservoirs angeordnet ist, um eine von der Ultraschalleinrichtung unabhängige Ausgestaltung des Ausgabemundstücks zu ermöglichen.

Bevorzugt ist es, wenn die Ultraschalleinrichtung mittels einer Haltereinrichtung lösbar am Behälterkörper des Lotkugelreservoirs angeordnet ist.

Wenn der Druckanschluss oberhalb eines im Lotkugelreservoir ausgebildeten Aufnahmeraums zur Aufnahme der Lotkugelmenge angeordnet ist, ist gewährleistet, dass eine für sämtliche Lotkugeln gleichmäßige Druckbeaufschlagung erfolgt.

Wenn der Druckanschluss in einem den Aufnahmeraum abdeckenden Behälterdeckel des Lotkugelreservoirs angeordnet ist, kann der Behälterkörper eine besonders einfache, vom Druckanschluss ungestörte Geometrie aufweisen.

Wenn zwischen dem Behälterdeckel und dem Behälterkörper eine Dichtungseinrichtung angeordnet ist kann ein durch Gasströmungen im Wesentlichen ungestörtes Druckpolster auf der im Behälterkörper aufgenommenen Lotkugelmenge ausgebildet werden.

Besonders vorteilhaft zur Ausbildung der "Ventilfunktion" ist es, wenn die Ausgabekanüle einen Kanaldurchmesser aufweist, der das 2- bis 8-fache des Lotkugeldurchmessers beträgt.

Eine Optimierung der "Ventilfunktion" wird möglich, wenn der Kanaldurchmesser das 4- bis 7-fache des Lotkugeldurchmessers beträgt. Hierdurch lassen sich besonders schnelle Reaktionszeiten des "Ventils" erreichen, so, dass zwischen einer Abschaltung der Ultraschallschwingungen und einer erneuten Blockade der Lotkugeln in der Ausgabekanüle möglichst wenig Zeit vergeht, und somit nach der Abschaltung allenfalls noch eine sehr geringe Menge von Lotkugeln aus der Ausgabekanüle ausströmt. Andererseits liegt nur eine möglichst kurze Zeitspanne zwischen der Einschaltung der Ultraschallschwingungen und der Auflösung einer Blockade von Lotkugeln in der Ausgabekanüle. Somit lässt sich insgesamt eine besonders hohe Dosiergenauigkeit erreichen.

Eine besonders schnelle Anpassung der Lotkugelzuführeinrichtung an unterschiedliche Einsatzbedingungen, die neben unterschiedlichen Durchmessern der Lotkugeln etwa auch durch die Umgebungstemperatur oder die Luftfeuchte beeinflusst sein können, wird möglich, wenn die Ausgabekanüle austauschbar an dem Ausgabemundstück angeordnet ist.

Die erfindungsgemäße Transfervorrichtung weist die Merkmale des Anspruchs 11 auf.

Erfindungsgemäß ist die Transfervorrichtung mit einer erfindungsgemäßen Lotkugelzuführeinrichtung verbunden. Weiterhin ist die Entnahmeeinrichtung der Transfervorrichtung mit einer Ultraschalleinrichtung zur Beaufschlagung der Entnahmeeinrichtung mit Ultraschallschwingungen versehen.

Die Beaufschlagung der Entnahmeeinrichtung mit Ultraschallschwingungen sorgt dafür, dass etwaige lokale Anhäufungen in der Lotkugelschicht infolge eines Befüllungsvorgangs der Entnahmeeinrichtung nicht entstehen bzw. sofort beseitigt werden, so dass eine ebene Schichtoberfläche der Lotkugelschicht gewährleistet ist. Somit kann sichergestellt werden, dass bei einer Vakuumbeaufschlagung der Lotkugelschicht zur Ausbildung einer definierten Lotkugelanordnung auf dem Transfersubstrat eine optimale Verteilung der Lotkugeln in der Entnahmeeinrichtung herrscht.

Insbesondere ersetzt die Aktivierung der Ultraschalleinrichtung eine ansonsten entweder manuell oder mit entsprechendem mechanischen Aufwand zu realisierende Rakelfunktion. Weiterhin kann die Ultraschallbeaufschlagung der Entnahmeeinrichtung sogar während der Vakuumbeaufschlagung des Transfersubstrats und der Ausbildung einer Lotkugelanordnung auf dem Transfersubstrat erfolgen, ohne diese zu behindern. Vielmehr unterstützt die Ultraschallbeaufschlagung der Entnahmeeinrichtung noch die Ausbildung der Lotkugelanordnung auf dem Transfersubstrat.

Die Verbindung der Entnahmeeinrichtung mit der mit einer Dosiereinrichtung versehenen Lotkugelzuführeinrichtung ermöglicht eine automatisierte oder selbsttätige Befüllung der Entnahmeeinrichtung. Durch die Ultraschallbeaufschlagung der Entnahmeeinrichtung ist gleichzeitig sichergestellt, dass unmittelbar nach einer über die Dosiereinrichtung erfolgten Befüllung oder Nachfüllung der Entnahmeeinrichtung eine Nivellierung der Oberfläche der Lotkugelschicht erfolgt, so dass eine definierte Füllstandshöhe gegeben ist.

Wenn die Lotkugelzuführeinrichtung über eine flexible Zuführung mit der Entnahmeeinrichtung verbunden ist, kann bei Bedarf die Ultraschallbeaufschlagung des Ausgabemundstücks entkoppelt von der Ultraschallbeaufschlagung der Entnahmeeinrichtung erfolgen bzw. umgekehrt. Natürlich ist es abweichend hiervon auch möglich, die Ultraschallbeaufschlagung der Entnahmeeinrichtung gleichzeitig mit der Ultraschallbeaufschlagung des Ausgabemundstücks durchzuführen.

Wenn die Entnahmeeinrichtung unterhalb der Bodenwandung eine Zuführeinrichtung zur Zuführung eines ionisierten Gases aufweist, kann die antistatische Wirkung des ionisierten Gases zur Erhöhung der Relativbeweglichkeit der in der Entnahmeeinrichtung angeordneten Lotkugeln genutzt werden.

Zur Unterstützung einer automatischen bzw. selbsttätigen Befüllung der Entnahmeeinrichtung mit Lotkugeln aus dem Lotkugelreservoir ist es vorteilhaft, wenn die Entnahmeeinrichtung mit einer Sensoreinrichtung zur Überwachung des Füllstands versehen ist, die mit der Dosiereinrichtung zusammenwirkt und somit bei Bedarf für eine Aktivierung oder Deaktivierung der Dosiereinrichtung bzw. ein Öffnen oder Schließen des als "Ventil" wirkenden Ausgabemundstücks sorgt.

Besonders kostengünstig ist es, wenn zur Ausbildung der Sensoreinrichtung an der Entnahmeeinrichtung in Füllstandshöhe eine Lichtschrankeneinrichtung angeordnet ist.

Vorteilhaft hinsichtlich einer funktionssicheren und kostengünstigen Ausgestaltung der Entnahmeeinrichtung ist es, wenn die Entnahmeeinrichtung eine ringförmige Umfangswandung aufweist, die mit einer aus einem Drahtgewebe gebildeten Bodenwandung versehen ist.

Nachfolgend wird eine Ausführungsform der Transfervorrichtung anhand der Zeichnung näher erläutert.

Es zeigen:
- **Fig. 1**: eine schematische Darstellung einer Transfervorrichtung mit einem innerhalb einer Entnahmeeinrichtung angeordneten Transfersubstrat;
- **Fig. 2**: die in **Fig. 1** dargestellte Entnahmeeinrichtung in einer Schnittansicht gemäß Schnittlinienverlauf II-II in **Fig. 1****.**
- **Fig. 3**: eine Ausführungsform der Lotkugelzuführeinrichtung.

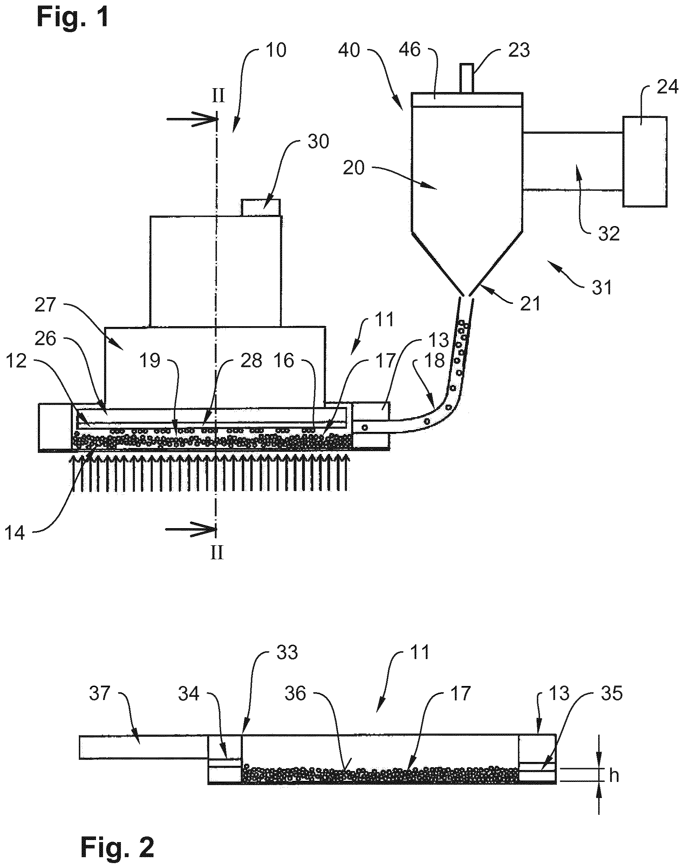

**Fig. 1** zeigt eine Transfervorrichtung 10 mit einem in einer Entnahmeeinrichtung 11 angeordneten Transfersubstrat 12. Die Entnahmeeinrichtung 11 weist eine ringförmig ausgebildete Umfangswandung 13 mit einer den unteren stirnseitigen Abschluss der Umfangswandung 13 bildenden Bodenwandung 14 auf. Die Bodenwandung 14 ist bei dem vorliegenden Ausführungsbeispiel aus einem netzartigen Drahtgewebe gebildet, das eine Maschenweite aufweist, die zumindest geringfügig kleiner ist als der Durchmesser von in der Entnahmeeinrichtung 11 angeordneten Lotkugeln 16, die in ihrer Gesamtheit eine Lotkugelschicht 17 in der Entnahmeeinrichtung 11 bilden.

Über eine hier elastisch ausgeführte Zuführleitung 18 ist ein Lotkugelaufnahmeraum 19, in dem sich die Lotkugelschicht 17 befindet, mit einem einen Vorratsspeicher bildenden Lotkugelreservoir 20 einer in **Fig. 1** lediglich schematisch dargestellten Lotkugelzuführeinrichtung 40 verbunden. An der Unterseite des Lotkugelreservoirs 20 ist als Schnittstelle zur Zuführleitung 18 ein Ausgabemundstück 21 angeordnet. Ein im Inneren des Lotkugelreservoirs 20 ausgebildeter Aufnahmeraum 22 ist über einen Druckanschluss 23 zur Einleitung eines unter Druck stehenden Gases versehen, wobei als Gas, insbesondere wegen seiner reduzierenden Wirkung, vorzugsweise Stickstoff verwendet wird. Die Lotkugelzuführeinrichtung 40 ist an einem Gestell 24 angeordnet, wobei zwischen dem Lotkugelreservoir 20 und dem Gestell 24 eine Wiegeeinrichtung angeordnet sein kann, die bei Bedarf einen Nachfüllvorgang des Lotkugelreservoirs 20 auslösen kann.

Das in **Fig. 1** innerhalb des Lotkugelaufnahmeraums 19 angeordnete Transfersubstrat 12 ist an einer Unterseite einer Anschlusseinrichtung 26 einer Handhabungseinrichtung 27 angeordnet. Die Handhabungsvorrichtung 27 bzw. eine die Handhabungsvorrichtung 27 aufnehmende Haltevorrichtung ist mit einer Vakuumeinrichtung bzw. einem Vakuumanschluss 30 versehen, der durch ein im Transfersubstrat 12 ausgebildetes, hier nicht näher dargestelltes Lochmuster hindurch eine rückwärtige Beaufschlagung des Lotkugelaufnahmeraums 19 der Entnahmeeinrichtung 11 mit einem Vakuum ermöglicht. Die Handhabungseinrichtung 27 dient zur Ausführung von räumlichen Zustellbewegungen des Transfersubstrats 12, so dass das Transfersubstrat 12 zum einen zur Entnahme einer Lotkugelanordnung 28 aus der Entnahmeeinrichtung 11 in die in **Fig. 1** dargestellte Entnahmeposition überführbar ist, und zum anderen eine Überführung der auf dem Transfersubstrat 12 angeordneten Lotkugelanordnung 28 in eine hier nicht näher dargestellte Kontaktierungsposition ermöglicht wird, in der sich die Lotkugelanordnung 28 in einer Überdeckung mit Kontaktstellen eines Kontaktsubstrats befindet. Um ausgehend von der Positionierung der Lotkugelanordnung 28 in einer Kontaktierungsposition unmittelbar nachfolgend die thermische Kontaktierung der Lotkugelanordnung 28 mit dem Kontaktsubstrat durchführen zu können, kann die Handhabungseinrichtung 27 auch als sogenannter "Bondkopf" ausgeführt sein, der eine thermische Beaufschlagung der Lotkugeln ermöglicht.

Im Betrieb der in **Fig. 1** dargestellten Transfervorrichtung erfolgt nachfolgend einer Positionierung des Transfersubstrats 12 im Lotkugelaufnahmeraum 19 der Entnahmeeinrichtung 11 eine Beaufschlagung des Lotkugelaufnahmeraums 19 mit einem am Vakuumanschluss 30 anliegenden Vakuum. Aufgrund der durch die perforierte Bodenwandung 14 der Entnahmeeinrichtung 11 erfolgenden Belüftung werden im Zusammenwirken mit dem Vakuum vereinzelte Lotkugeln 16 aus der Lotkugelschicht 17 zur Ausbildung der in **Fig. 1** dargestellten Lotkugelanordnung 28 in dem im Transfersubstrat 12 ausgebildeten Lochmuster überführt.

Dabei kann die Ausbildung der Lotkugelanordnung 28 noch durch eine Ultraschallbeaufschlagung der das Transfersubstrat 12 aufnehmenden Anschlusseinrichtung 26 unterstützt werden.

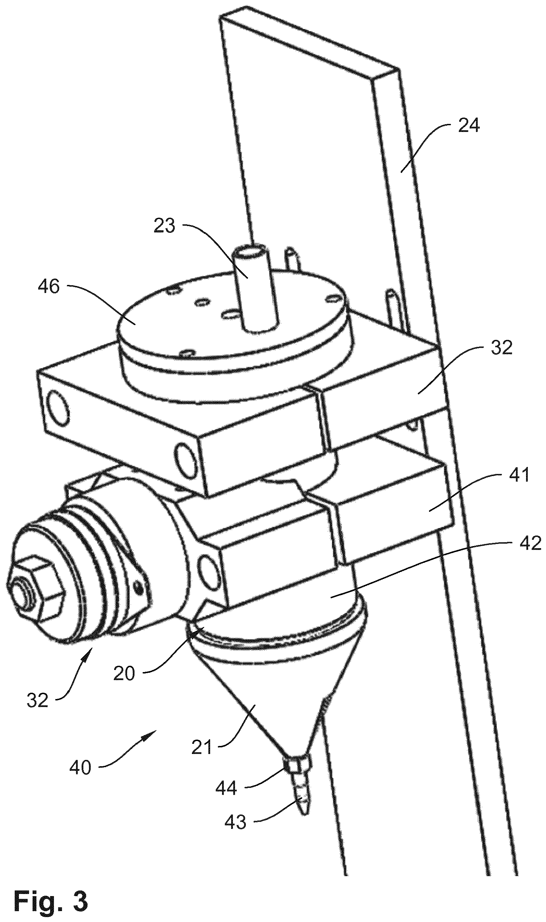

Um für eine ausreichende Befüllung des Lotkugelaufnahmeraums 19 zu sorgen, erfolgt im Bedarfsfall über die Lotkugelzuführeinrichtung 40 eine Auffüllung des Lotkugelaufnahmeraums 19 mit Lotkugeln 16 aus dem Lotkugelreservoir 20. Eine dem Bedarf entsprechende Dosierung der Zufuhr von Lotkugeln 16 aus dem Lotkugelreservoir 20 erfolgt vermittels einer Dosiereinrichtung 31, die das Ausgabemundstück 21 und eine das Ausgabemundstück 21 mit Schwingungen beaufschlagende Ultraschalleinrichtung 32 umfasst, welche, wie insbesondere der in **Fig. 3** dargestellten Ausführungsform entnommen werden kann, mittels einer Halteinrichtung 41 an einem Behälterkörper 42 des Lotkugelreservoirs 20 angeordnet ist.

Zur Auslösung bzw. Steuerung der Dosiereinrichtung 31 ist, wie in **Fig. 2** dargestellt, die Entnahmeeinrichtung 11 mit einer Lichtschrankeneinrichtung 33 versehen, die im Falle des vorliegenden Ausführungsbeispiels einen Sender 34 und einen Empfänger 35 aufweist, die jeweils an einander gegenüberliegenden Stellen in der Umfangswandung 13 der Entnahmeeinrichtung 11 angeordnet sind. Wenn die im Lotkugelaufnahmeraum 19 der Entnahmeeinrichtung 11 ausgebildete Lotkugelschicht 17 eine durch die Lichtschrankeneinrichtung 33 definierte Füllstandshöhe h unterschreitet, wird zwischen dem Sender 34 und dem Empfänger 35 ein Kontakt ausgelöst, der die Dosiereinrichtung 31 in Betrieb setzt.

Zur Sicherstellung einer im Wesentlichen ebenen oder bodenwandungsparallelen Schichtoberfläche 36 ist an der Umfangswandung 13 eine Ultraschalleinrichtung 37 vorgesehen, die die Entnahmeeinrichtung 11 mit Ultraschallschwingungen beaufschlagt und so für eine im Wesentlichen gleichmäßige Verteilung der Lotkugeln 16, also eine im Wesentlichen zur Bodenwandung 14 parallele Schichtoberfläche 36 der Lotkugelschicht 17, sorgt.

Die Auslösung der Dosiereinrichtung 31 erfolgt über eine Aktivierung der Ultraschalleinrichtung 32, die das Ausgabemundstück 21 mit Ultraschallschwingungen beaufschlagt. Das Ausgabemundstück 21 weist einen hier durch eine Ausgabekanüle 43 ausgebildeten Ausgabekanal auf. Die Ausgabekanüle 43 ist im vorliegenden Fall mittels einer Überwurfmutter 44 austauschbar am Ausgabemundstück 21 angeordnet. Der Öffnungsquerschnitt der Ausgabekanüle 43 ist so bemessen ist, dass ein Verkeilen der Lotkugeln 16 im Öffnungsquerschnitt und somit eine Blockade erfolgen kann. Das Auftreten des Verkeilungseffekts ist beispielsweise von der Luftfeuchtigkeit und der Sauerstoffzufuhr im Lotkugelreservoir 20 abhängig.

Im Behälterdeckel 46 ist ein Druckanschluss 23 angeordnet. Durch eine Druckbeaufschlagung der im Aufnahmeraum 22 aufgenommenen Lotkugelmenge mittels eines auf die Lotkugelmenge wirkenden Druckpolsters und einer die Lotkugelmenge durchdringenden und aus der Ausgabekanüle 43 austretenden Gasströmung wird bei gleichzeitiger Beaufschlagung des Ausgabebemundstücks 21 mit Schwingungen die Blockade gelöst, so dass über die Zuführleitung 18 (**Fig. 1**) ein Nachfüllen der Entnahmeeinrichtung 11 mit Lotkugeln 16 erfolgen kann. Die Ultraschallbeaufschlagung des Ausgabemundstücks 21 bewirkt, dass in der Ausgabekanüle 43 des Ausgabemundstücks 21 verkeilt gegeneinander angeordnete Lotkugeln 16 in eine vibrations-induzierte Relativbewegung versetzt werden, die die Fixierung der Lotkugeln 16 in der Ausgabekanüle 43 löst und ein Ausströmen von im Lotkugelreservoir 20 angeordneten Lotkugeln 16 durch die Ausgabekanüle 43 und die Zuführleitung 18 in den Lotkugelaufnahmeraum 19 der Entnahmeeinrichtung 11 ermöglicht.

Mit Unterbrechung der Schwingungsbeaufschlagung durch Abschaltung der Ultraschalleinrichtung 32 mittels der Lichtschrankeneinrichtung 33 nach Wiedererreichen der definierten Füllstandshöhe h bildet sich in der Ausgabekanüle 43 eine erneute Blockade aus, so dass die Zuführung weiterer Lotkugeln 16 in die Entnahmeeinrichtung 11 unterbrochen wird.

Durch Austauschen der Ausgabekanüle 43 kann der Öffnungsquerschnitt des Ausgabekanals einfach an unterschiedliche Lotkugeldurchmesser angepasst werden, um den Ventileffekt für unterschiedliche Lotkugeldurchmesser zu erreichen.

## Patentansprüche

1. Lotkugelzuführeinrichtung (40), umfassend ein Lotkugelreservoir (20) zur Aufnahme einer Lotkugelmenge und eine Dosiereinrichtung (31) zur Ausgabe einer dosierten Zuführmenge von Lotkugeln (16) an eine Entnahmeeinrichtung (11),
wobei die Dosiereinrichtung (31) ein Ausgabemundstück (21) mit einer Ausgabekanüle (43) umfasst,
wobei das Lotkugelreservoir (20) oder das Ausgabemundstück (21) des Lotkugelreservoirs (20) mit einem Druckanschluss (23) versehen ist, der zur Einleitung eines unter Druck stehenden Gases in die Lotkugelzuführeinrichtung (40) dient,
**dadurch gekennzeichnet,**
**dass** die Dosiereinrichtung (31) eine Ultraschalleinrichtung (32) umfasst, wobei die Ultraschalleinrichtung (32) zur Beaufschlagung des Ausgabemundstücks mit Schwingungen dient.

2. Lotkugelzuführeinrichtung nach Anspruch 1,
**dadurch gekennzeichnet,**
**dass** die Ultraschalleinrichtung (32) unabhängig vom Ausgabemundstück (21) ausgebildet ist.

3. Lotkugelzuführeinrichtung nach Anspruch 2,
**dadurch gekennzeichnet,**
**dass** die Ultraschalleinrichtung (32) an einem Behälterkörper (42) des Lotkugelreservoirs (20) angeordnet ist.

4. Lotkugelzuführeinrichtung nach Anspruch 3,
**dadurch gekennzeichnet,**
**dass** die Ultraschalleinrichtung (32) mittels einer Haltereinrichtung (41) lösbar am Behälterkörper (42) des Lotkugelreservoirs (20) angeordnet ist.

5. Lotkugelzuführeinrichtung nach einem der vorangehenden Ansprüche,
**dadurch gekennzeichnet,**
**dass** der Druckanschluss (23) oberhalb eines im Lotkugelreservoir (20) ausgebildeten Aufnahmeraums (22) zur Aufnahme der Lotkugelmenge angeordnet ist.

6. Lotkugelzuführeinrichtung nach Anspruch 5,
**dadurch gekennzeichnet,**
**dass** der Druckanschluss (23) in einem den Aufnahmeraum (22) abdeckenden Behälterdeckel (46) des Lotkugelreservoirs (20) angeordnet ist.

7. Lotkugelzuführeinrichtung nach Anspruch 6,
**dadurch gekennzeichnet,**
**dass** zwischen dem Behälterdeckel (46) und dem Behälterkörper (42) eine Dichtungseinrichtung angeordnet ist.

8. Lotkugelzuführeinrichtung nach einem der vorangehenden Ansprüche,
**dadurch gekennzeichnet,**
**dass** die Ausgabekanüle (43) einen Kanaldurchmesser aufweist, der das 2- bis 8-fache des Lotkugeldurchmessers beträgt.

9. Lotkugelzuführeinrichtung nach Anspruch 8,
**dadurch gekennzeichnet,**
**dass** der Kanaldurchmesser das 4- bis 7-fache des Lotkugeldurchmessers beträgt.

10. Lotkugelzuführeinrichtung nach einem der vorangehenden Ansprüche,
**dadurch gekennzeichnet,**
**dass** die Ausgabekanüle (43) austauschbar an dem Ausgabemundstück (21) angeordnet ist.

11. Transfervorrichtung (10) zur Aufnahme einer Lotkugelanordnung (28) aus einer Entnahmeeinrichtung (11), wobei die Transfervorrichtung (10) mit einer Lotkugelzuführeinrichtung (40) nach einem der Ansprüche 1 bis 10 verbunden ist, wobei die Transfervorrichtung (10) die Entnahmeeinrichtung (11) aufweist,
wobei die Transfervorrichtung (10) zur Ausbildung einer ebenen Lotkugelanordnung (28) ein mit der Entnahmeeinrichtung (11) zusammenwirkendes und mit Unterdruck beaufschlagbares Transfersubstrat (12) aufweist, wobei die Entnahmeeinrichtung (11) eine zumindest bereichsweise perforierte Bodenwandung (14) und das Transfersubstrat (12) ein Lochmuster zur Aufnahme der Lotkugelanordnung aufweist,
wobei die Entnahmeeinrichtung (11) mit einer Ultraschalleinrichtung (37) zur Beaufschlagung der Entnahmeeinrichtung (11) mit Ultraschallschwingungen versehen ist.

12. Transfervorrichtung (10) nach Anspruch 11,
**dadurch gekennzeichnet,**
**dass** die Ausgabekanüle (43) mit einer flexiblen Leitung (18) zur Zuführung der dosierten Zuführmenge zu der Entnahmeeinrichtung (11) versehen ist.

13. Transfervorrichtung (10) nach Anspruch 11 oder 12,
**dadurch gekennzeichnet,**
**dass** die Entnahmeeinrichtung (11) unterhalb der Bodenwandung (14) eine Zuführeinrichtung zur Zuführung eines ionisierten Gases aufweist.

14. Transfervorrichtung (10) nach einem der Ansprüche 11 bis 13,
**dadurch gekennzeichnet,**
**dass** die Entnahmeeinrichtung (11) mit einer Sensoreinrichtung zur Überwachung der Füllstandshöhe h versehen ist, die mit der Dosiereinrichtung (31) zusammenwirkt.

15. Transfervorrichtung (10) nach Anspruch 14,
**dadurch gekennzeichnet,**
**dass** zur Ausbildung der Sensoreinrichtung an der Entnahmeeinrichtung (11) in Füllstandshöhe h eine Lichtschrankeneinrichtung (33) angeordnet ist.

## Claims

1. A solder ball feeding device (40), comprising a solder ball reservoir (20) for receiving an amount of solder balls and a metring device (31) for dispensing a metred feeding amount of solder balls (16) to a discharge device (11),
the metring device (31) comprising a dispensing nozzle (21) with a dispensing cannula (43),
the solder ball reservoir (20) or the dispensing nozzle (21) of the solder ball reservoir (20) being provided with a pressure connection (23) which serves to introduce a pressurized gas into the solder ball feeding device (40)
**characterised in that**
the metring device (31) comprises an ultrasound device (32), the ultrasound device (32) serving to apply vibrations to the dispensing nozzle.

2. The solder ball feeding device according to claim 1,
**characterised in that**
the ultrasound device (32) is embodied independent of the dispensing nozzle (21).

3. The solder ball feeding device according to claim 2,
**characterised in that**
the ultrasound device (32) is disposed on a container body (42) of the solder ball reservoir (20).

4. The solder ball feeding device according to claim 3,
**characterised in that**
the ultrasound device (32) is disposed on the container body (42) of the solder ball reservoir (20) in a detachable manner by means of a support device (41).

5. The solder ball feeding device according to any of the preceding claims,
**characterised in that**
the pressure connection (23) is disposed above a receiving chamber (22) formed in the solder ball reservoir (20) and serving to receive the amount of solder balls.

6. The solder ball feeding device according to claim 5,
**characterised in that**
the pressure connection (23) is disposed in a container lid (46) of the solder ball reservoir (20), said container lid covering the receiving chamber (22).

7. The solder ball feeding device according to claim 6,
**characterised in that**
a sealing device is disposed between the container lid (46) and the container body (42).

8. The solder ball feeding device according to any of the preceding claims,
**characterised in that**
the dispensing cannula (43) has a duct diameter that is 2 to 8 times as large as the diameter of the solder balls.

9. The solder ball feeding device according to claim 8,
**characterised in that**
the duct diameter is 4 to 7 times as large as the diameter of the solder balls.

10. The solder ball feeding device according to any of the preceding claims,
**characterised in that**
the dispensing cannula (43) is disposed in an exchangeable manner on the dispensing nozzle (21).

11. A transfer device (10) for receiving a solder ball array (28) from a discharge device (11), the transfer device (10) being connected to a solder ball feeding device (40) according to any of the claims 1 to 10, the transfer device (10) comprising the discharge device (11),
wherein, for forming an even solder ball array (28), the transfer device (10) has a transfer substrate (12) that interacts with the discharge device (11) and that can be subjected to negative pressure, the discharge device (11) having a bottom wall (14) perforated at least in sections and the transfer substrate (12) having a hole pattern for receiving the solder ball array,
wherein the discharge device (11) is provided with an ultrasound device (37) for applying ultrasonic vibrations to the discharge device (11).

12. The transfer device (10) according to claim 11,
**characterised in that**
the dispensing cannula (43) is provided with a flexible duct (18) for feeding the metred feeding amount to the discharge device (11).

13. The transfer device (10) according to claim 11 or 12,
**characterised in that**
the discharge device (11) has a supplying device beneath the bottom wall (14) for supplying an ionized gas.

14. The transfer device (10) according to any of the claims 11 to 13,
**characterised in that**
the discharge device (11) is provided with a sensor device for monitoring the filling level height h, said sensor device interacting with the metering device (31).

15. The transfer device (10) according to claim 14,
**characterised in that**
for forming the sensor device, a light barrier device (33) is disposed on the discharge device (11) at the filling level height h.

## Revendications

1. Dispositif (40) d'alimentation en billes de soudure, comprenant un réservoir (20) de billes de soudure destiné à recevoir une quantité de billes de soudure et un dispositif de dosage (31) destiné à distribuer une quantité d'alimentation dosée de billes de soudure (16) à un dispositif de prélèvement (11),
le dispositif de dosage (31) comprenant un embout de distribution (21) ayant une canule de distribution (43),
le réservoir (20) de billes de soudure ou l'embout de distribution (21) du réservoir (20) de billes de soudure étant muni d'un raccord de pression (23) qui sert à introduire un gaz sous pression dans le dispositif (40) d'alimentation en billes de soudure,
**caractérisé en ce que**
le dispositif de dosage (31) comprend un dispositif ultrasonique (32), le dispositif ultrasonique (32) servant à appliquer des vibrations à l'embout de distribution.

2. Dispositif d'alimentation en billes de soudure selon la revendication 1,
**caractérisé en ce que**
le dispositif ultrasonique (32) est réalisé indépendamment de l'embout de distribution (21).

3. Dispositif d'alimentation en billes de soudure selon la revendication 2,
**caractérisé en ce que**
le dispositif ultrasonique (32) est disposé sur un corps de récipient (42) du réservoir (20) de billes de soudure.

4. Dispositif d'alimentation en billes de soudure selon la revendication 3,
**caractérisé en ce que**
le dispositif ultrasonique (32) est disposé sur le corps de récipient (42) du réservoir (20) de billes de soudure de manière amovible par l'intermédiaire d'un moyen de support (41).

5. Dispositif d'alimentation en billes de soudure selon l'une quelconque des revendications précédentes,
**caractérisé en ce que**
le raccord de pression (23) est disposé au-dessus d'une chambre de réception (22) formée dans le réservoir (20) de billes de soudure et destinée à recevoir la quantité de billes de soudure.

6. Dispositif d'alimentation en billes de soudure selon la revendication 5,
**caractérisé en ce que**
le raccord de pression (23) est disposé dans un couvercle de récipient (46) du réservoir (20) de billes de soudure, ledit couvercle de récipient couvrant la chambre de réception (22).

7. Dispositif d'alimentation en billes de soudure selon la revendication 6,
**caractérisé en ce qu'**
un moyen d'étanchéité est disposé entre le couvercle de récipient (46) et le corps de récipient (42).

8. Dispositif d'alimentation en billes de soudure selon l'une quelconque des revendications précédentes,
**caractérisé en ce que**
la canule de distribution (43) a un diamètre de canal qui est 2 à 8 fois le diamètre des billes de soudure.

9. Dispositif d'alimentation en billes de soudure selon la revendication 8,
**caractérisé en ce que**
le diamètre de canal est 4 à 7 fois le diamètre des billes de soudure.

10. Dispositif d'alimentation en billes de soudure selon l'une quelconque des revendications précédentes,
**caractérisé en ce que**
la canule de distribution (43) est disposée de manière échangeable sur l'embout de distribution (21).

11. Dispositif de transfert (10) destiné à recevoir un ensemble (28) de billes de soudure à partir d'un dispositif de prélèvement (11), le dispositif de transfert (10) étant relié avec un dispositif (40) d'alimentation en billes de soudure selon l'une quelconque des revendications 1 à 10, le dispositif de transfert (10) comprenant le dispositif de prélèvement (11),
dans lequel, pour la formation d'un ensemble (28) de billes de soudure plat, le dispositif de transfert (10) a un substrat de transfert (12) qui interagit avec le dispositif de prélèvement (11) et qui peut être mis sous vide, le dispositif de prélèvement (11) ayant une paroi de fond (14) perforée au moins par zones et le substrat de transfert (12) ayant un motif à trous destiné à recevoir l'ensemble de billes de soudure,
dans lequel le dispositif de prélèvement (11) est muni d'un dispositif ultrasonique (37) destiné à appliquer des vibrations ultrasoniques au dispositif de prélèvement (11).

12. Dispositif de transfert (10) selon la revendication 11,
**caractérisé en ce que**
la canule de distribution (43) est munie d'une conduite flexible (18) destinée à alimenter de manière dosée le dispositif de prélèvement (11) en la quantité d'alimentation dosée.

13. Dispositif de transfert (10) selon la revendication 11 ou 12,
**caractérisé en ce qu'**
au-dessous de la paroi de fond (14), le dispositif de prélèvement (11) a un dispositif d'alimentation pour l'alimentation en gaz ionisé.

14. Dispositif de transfert (10) selon l'une quelconque des revendications 11 à 13,
**caractérisé en ce que**
le dispositif de prélèvement (11) est muni d'un dispositif capteur destiné à surveiller la hauteur h du niveau de remplissage, le dispositif capteur interagissant avec le dispositif de dosage (31).

15. Dispositif de transfert (10) selon la revendication 14,
**caractérisé en ce que**
pour la formation du dispositif capteur, un dispositif de barrière lumineuse (33) est disposé sur le dispositif de prélèvement (11) à la hauteur h du niveau de remplissage.
